# EUROPEAN PATENT SPECIFICATION

(11) **EP 4 379 995 B1**
(45) Date of publication and mention of the grant of the patent: **19.11.2025**
(21) Application number: 22901530.0
(22) Date of filing: 23.09.2022
(51) Int. Cl.: H02J 7/00, H02J 7/34, H01M 10/42

(54) **BATTERY DEVICE AND BALANCING METHOD**
BATTERIEVORRICHTUNG UND AUSGLEICHSVERFAHREN
DISPOSITIF DE BATTERIE ET PROCÉDÉ DE COMPENSATION

(30) Priority: 30.11.2021 KR 20210168956
(43) Date of publication of application: 05.06.2024
(73) Proprietor: LG Energy Solution, Ltd., Seoul 07335 (KR)
(72) Inventor: JEON, Younghwan, Daejeon 34122 (KR)
(74) Representative: Plasseraud IP
(86) International application number: PCT/KR2022/014261
(87) International publication number: WO 2023/101170

(56) References cited:
- EP-A1- 2 793 349
- JP-A- 2017 108 484
- JP-A- H05 182 694
- KR-A- 20140 096 600
- KR-A- 20200 084 710
- US-A1- 2013 187 605
- US-A1- 2015 015 209
- US-A1- 2018 219 387

## Description

### [Technical Field]

The disclosure relates to a battery device and a balancing method.

### [Background Art]

An electric vehicle is a vehicle that obtains power by driving a motor using a battery as a power source mainly, and its research has been actively conducted in that it is an alternative to solving the pollution and energy problems of internal combustion vehicles. In addition, rechargeable batteries are used in various external devices other than electric vehicles.

Recently, a battery device in which a plurality of battery packs are connected in parallel has been used as a battery having high output and large charging capacity is required. When a voltage difference occurs between battery cells in a battery pack, a voltage difference may be reduced through cell balancing, but balancing that reduces the voltage difference between battery packs is not used. In addition, since a balancing operation takes a long time, it is necessary to solve a problem in that the battery pack does not supply power while balancing between battery packs is performed.

US2018/219387 A1 relates to an electric storage apparatus, JP H05 182694 A relates to a discharge circuit for a battery, and EP2793349 A1 relates to an apparatus for battery balancing.

### [Disclosure]

### [Technical Problem]

Certain embodiments may provide a battery device and a balancing method capable of balancing between battery packs.

### [Technical Solution]

According to an aspect, a battery device according to claim 1 is provided.

The first predetermined condition may include a condition in which a voltage difference between the first battery pack and the second battery pack exceeds a threshold voltage.

The first battery pack may be a battery pack having a highest voltage among the plurality of battery packs, and the second battery pack may be a battery pack having a lowest voltage among the plurality of battery packs.

The first predetermined condition may include a condition in which the battery device is in a mode in which power supply from the battery device to the external device is not required.

The processor may end the balancing when a second predetermined condition is satisfied.

The second predetermined condition may include a condition in which a voltage difference between the first battery pack and the second battery pack is less than a predetermined voltage.

The second predetermined condition may include a condition in which the battery device is in a mode in which power supply from the battery device to the external device is required.

According to another aspect, a battery device according to claim 8 is provided.

The balancing circuit may further include a resistor connected between the first node and the second node when performing the balancing.

The first predetermined condition may include a condition in which a voltage difference between the first battery pack and the second battery pack exceeds a threshold voltage.

The first predetermined condition may further include a condition in which the battery device is in a mode in which power supply from the battery device to the external device is not required.

The processor may end the balancing when a second predetermined condition is satisfied.

The second predetermined condition may include a condition in which a voltage difference between the first battery pack and the second battery pack is less than a predetermined voltage.

The second predetermined condition may include a condition in which the battery device is in a mode in which power supply from the battery device to the external device is required.

According to another aspect, a balancing method according to claim 11 is provided.

The predetermined condition may include a condition in which a voltage difference between the first battery pack and the second battery pack exceeds a threshold voltage.

The predetermined condition may further include a condition in which the battery device is in a mode in which power supply from the battery device to the external device is not required.

### [Advantageous Effect]

According to some embodiments, since a battery pack having a high voltage may charge a battery pack having a low voltage, balancing may be performed between the battery packs.

### [Description of the Drawings]

FIG. 1 is a diagram showing an example of a battery device according to an embodiment.
FIG. 2 is a diagram showing an example of a battery device according to another embodiment.
FIG. 3 is a diagram showing an example of switching timing of the battery device shown in FIG. 2.
FIG. 4 is a flowchart illustrating an example of a battery pack balancing method of a battery device according to an embodiment.

### [Mode for Invention]

Hereinafter, the present invention will be described in detail with reference to the accompanying drawings so that those skilled in the art may easily carry out the present invention. In order to clearly describe the present invention, parts irrelevant to the description are omitted, and the same reference numerals are denoted by the same or similar components throughout the specification.

It will be understood that when a component is referred to as being "connected" to another component, the component may be directly connected to the other component, but other components may exist therebetween. On the other hand, it will be understood that when a component is referred to as being "directly connected" to another component, no other component exists therebetween.

In the description below, expressions described in the singular may be interpreted as singular or plural, unless explicit expressions such as "one" or "single" are used.

In the flowchart described with reference to the drawings, the order of operations may be changed, several operations may be merged, an operation may be divided, and certain operations may not be performed.

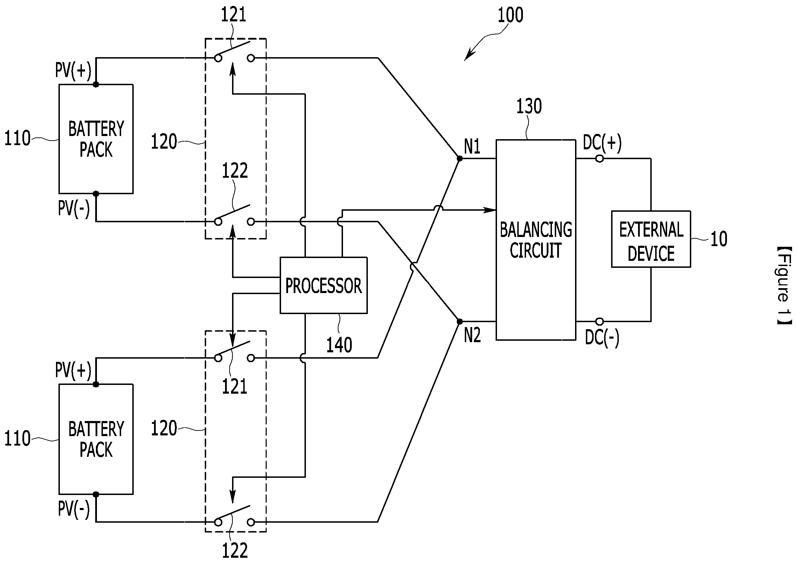

FIG. 1 is a diagram showing an example of a battery device according to an embodiment.

Referring to FIG. 1, the battery device 100 has a structure that may be electrically connected to an external device 10 through a positive link terminal DC(+) and a negative link terminal DC(-). In some embodiments, the battery device 100 may be connected to the external device 10 through the positive link terminal DC(+) and the negative link terminal DC(-). When the external device 10 is a load, the battery device 100 may be discharged by operating as a power source supplying power to the load. When the external device 10 is a charger, the battery device 100 may be charged by receiving external power through the charger 10. In some embodiments, the external device 10 operating as a load may be, for example, an electronic device, a transportation means, or an energy storage system (ESS), and the transportation means may be a vehicle, for example, an electric vehicle, a hybrid vehicle, or a smart mobility vehicle.

The battery device 100 includes a plurality of battery packs 110, a plurality of switching circuits 120, a balancing circuit 130, and a processor 140.

The plurality of battery packs 110 are connected in parallel to the link terminals DC(+) and DC(-) through the plurality of switching circuits 120. The plurality of switching circuits 120 respectively correspond to the plurality of battery packs 110. That is, each switching circuit 120 is connected to the corresponding battery pack 110 among the plurality of battery packs 110. Each battery pack 110 includes a plurality of battery cells (not shown), and has a positive terminal PV(+) and a negative terminal PV(-). In some embodiments, the battery cell may be a rechargeable secondary battery. In an embodiment, a predetermined number of battery cells may be in series connected in the battery pack 110 to form a battery module and supply desired power. In another embodiment, a predetermined number of battery modules may be connected in series or parallel in the battery pack 110 to supply desired power.

Each switching circuit 120 includes a positive switch 121 and a negative switch 122. The positive switch 121 is connected between the corresponding positive terminal PV(+) of the battery pack 110 and a node N1. The node N1 may be connected to the positive link terminal DC(+) of the battery device 100 through the balancing circuit 130. The negative switch 122 is connected between the corresponding negative terminal PV(-) of the battery pack 110 and a node N2. The node N2 may be connected to the negative link terminal DC(-) of the battery device 100 through the balancing circuit 130. The switches 121 and 122 may be controlled by the processor 140 to control electrical connection between the battery pack 110 and the external device 10. In some embodiments, each of the switches 121 and 122 may include a contactor that includes a relay. In some embodiments, each of the switches 121 and 122 may include an electrical switch such as a transistor. In some embodiments, the switching circuit 120 may further include a driving circuit (not shown) driving each of the switches 121 and 122 in response to a control signal from the processor 140. When the positive switch 121 and the negative switch 122 are closed, power may be supplied from the battery pack 110 to the external device 10 or from the external device 10 to the battery pack 110. Closing of a switch may be expressed as turning on the switch, and opening of the switch may be expressed as turning off the switch.

The balancing circuit 130 is connected between the nodes N1 and N2 and the link terminals DC(+) and DC(-). During balancing, the balancing circuit 130 blocks a connection between the node N1 and the positive link terminal DC(+) and a connection between the node N2 and the negative link terminal DC(-), and performs balancing between the selected battery packs 110. The balancing circuit 130 may perform balancing so that the battery pack 110 having a low voltage is charged by the battery pack 110 having a high voltage. When balancing is not performed, the balancing circuit 130 connects the node N1 to the positive link terminal DC(+) and connects the node N2 to the negative link terminal DC(-). Accordingly, when the positive switch 121 and the negative switch 122 are closed, power may be supplied from the battery pack 110 to the external device 10 or from the external device 10 to the battery pack 110.

The processor 140 controls the plurality of switching circuits 120 and the balancing circuit 130. In some embodiments, the processor 140 may include, for example, a micro controller unit (MCU). The processor 140 performs balancing among at least some battery packs among the plurality of battery packs 110 when a predetermined condition (or a "first predetermined condition") is satisfied. During balancing, the processor 140 may close the positive switch 121 and the negative switch 122 of the battery pack 110 selected for balancing from among the plurality of battery packs 110, and control the balancing circuit 130 to block the connection between the node N1 and the positive link terminal DC(+) and the connection between the node N2 and the negative link terminal DC(-). When balancing is not performed, the processor 140 may control the balancing circuit 130 so that the node N1 is connected to the positive link terminal DC(+) and the node N2 is connected to the negative link terminal DC(-).

In some embodiments, the predetermined condition may include a condition in which a voltage difference between battery packs performing balancing exceeds a threshold voltage. In some embodiments, the processor 140 may select the battery pack 110 having the highest voltage and the battery pack 110 having the lowest voltage from among the plurality of battery packs 110 as the battery pack 110 for balancing. In some embodiments, when selecting the battery pack 110 having the highest voltage, the processor 140 may select one or more battery packs 110 having the highest voltage from among the plurality of battery packs 110. When selecting the battery pack 110 having the lowest voltage, the processor 140 may select one or more battery packs 110 having the lowest voltage from among the plurality of battery packs 110. When the difference between the highest voltage and the lowest voltage exceeds the threshold voltage, the processor 140 may perform balancing between the battery pack 110 having the highest voltage and the battery pack 110 having the lowest voltage.

In some embodiments, the predetermined condition may include a condition in which the battery device 100 is in a balancing mode. In some embodiments, the balancing circuit 130 may perform balancing under the control of the processor 140 in the balancing mode. In some embodiments, the balancing circuit 130 may not perform balancing under the control of the processor 140 in a power source mode. In some embodiments, the balancing mode is a mode in which power supply from the battery device 100 to the external device 10 is not required, and may include an idle period of the battery device 100. The power source mode may be a mode in which the battery device 100 operates as a power source for supplying power to the external device 10. In some embodiments, the idle period may include a pre-sleep mode immediately before a battery management system including the processor 140 enters a sleep mode. In some embodiments, when the external device 10 is a transportation means, the balancing mode may include a parking mode in which the transportation means is parked, and the power source mode may include a driving mode in which the transportation means is driving.

In some embodiments, the battery device 100 may further include a monitoring circuit monitoring the voltage of the battery pack 110. The processor 140 may receive a monitoring result from the monitoring circuit and detect the voltage of the battery pack 110.

According to the embodiment described above, since the battery pack 110 having a low voltage may be charged with the battery pack 110 having a high voltage, balancing may be performed between the battery packs 110. In some embodiments, balancing may be stably performed by performing balancing in the balancing mode including the parking mode.

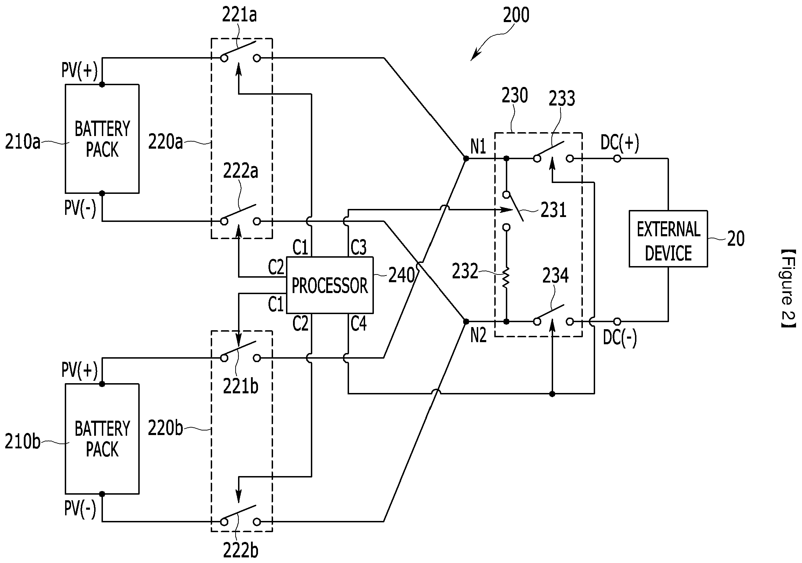

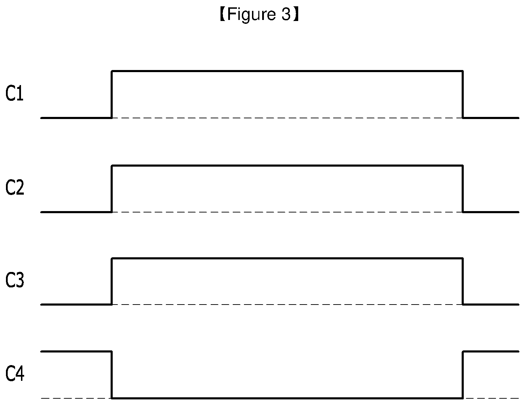

FIG. 2 is a diagram illustrating an example of a battery device according to another embodiment, and FIG. 3 is a diagram illustrating an example of switching timing of the battery device illustrated in FIG. 2. FIG. 2 shows two battery packs selected for balancing, for convenience of description. FIG. 3 shows an enable level of a control signal as a high level and a disable level of the control signal as a low level, for convenience of description.

Referring to FIG. 2, the battery device 200 includes a plurality of battery packs 210a and 210b, a plurality of switching circuits 220a and 220b, a balancing circuit 230 and a processor 240.

As described with reference to FIG. 1, the switching circuit 220a includes a positive switch 221a and a negative switch 222a, and the switching circuit 220b includes a positive switch 221b and a negative switch 222b. The positive switch 221a is connected between the positive terminal PV(+) of the battery pack 210a and the node N1, and the negative switch 222a is connected between the negative terminal PV(-) of the battery pack 210a and the node N2. The positive switch 221b is connected between the positive terminal PV(+) of the battery pack 210b and the node N1, and the negative switch 222b is connected between the negative terminal PV(-) of the battery pack 210b and the node N2.

The balancing circuit 230 includes a balancing switch 231, a balancing resistor 232 and connection switches 233 and 234. The balancing switch 231 and the balancing resistor 232 are connected in series between the node N1 and the node N2. In some embodiments, the connection switch 233 is connected between the node N1 and the positive link terminal DC (+), and is used to connect the positive switches 221a and 221b with the positive link terminal DC(+). The connection switch 234 is connected between the node N2 and the negative link terminal DC(-), and is used to connect the negative switches 222a and 222b with the negative link terminal DC(-).

In some embodiments, each of the switches 221a, 221b, 222a, 222b, 231, 233, and 234 may include a contactor that includes a relay. In some embodiments, each of the switches 221a, 221b, 222a, 222b, 231, 233, and 234 may include an electrical switch such as a transistor. In some embodiments, the balancing resistor 232 may include a cement resistor.

Referring to FIGS. 2 and 3, in a balancing mode, the processor 240 transfers a control signal C4 having the disable level to each of the connection switches 233 and 234, and the connection switches 233 and 234 are opened in response to the control signal C4 having the disable level. The connection switches 233 and 234 are opened, and a connection between the node N1 and the link terminal DC(+) and a connection between the node N2 and the link terminal DC(-) are blocked.

Also, the processor 240 transfers a control signal C3 having the enable level to the balancing switch 231, and the balancing switch 231 is closed in response to the control signal C3 having the enable level. The balancing switch 231 is closed so that the node N1 and the node N2 are connected through the balancing resistor 232. That is, the balancing resistor 232 is connected in parallel to the battery packs 210a and 210b.

In addition, the processor 240 transfers control signals C1 and C2 having the enable level to the switching circuits 220a and 220b of the battery packs 210a and 210b selected for balancing, and the negative switches 222a and 222b of the battery packs 210a and 210b are closed in response to the control signal C2 having the enable level, and the positive switches 221a and 221b of the battery packs 210a and 210b are closed in response to the control signal C1 having the enable level. The processor 240 transfers a control signal having the disable level to a switching circuit of the remaining battery pack, and a positive switch and a negative switch of the battery pack not selected for balancing maintains an open state in response to the control signal having the disable level.

Accordingly, a current may flow from the battery pack (e.g., 210a) having a high voltage to the balancing resistor 232 and the battery pack (e.g., 210b) having a low voltage. In this case, the battery pack 210b may be charged according to the current flowing from the battery pack 210a to the battery pack 210b and the balancing resistor 232 and supplied to the battery pack 210b according to a ratio between the internal resistance of the battery pack 210b and the balancing resistor 232. Accordingly, the voltage of the battery pack 210b increases, and balancing may be performed between the battery packs 210a and 210b. In this case, the balancing resistor 232 may limit the current supplied to the battery pack 210b so that an excessive current is not supplied to the battery pack 210b.

To end the balancing mode, the processor 240 transfers the control signal C3 having the disable level to the balancing switch 231 and the control signal C4 having the enable level to the connection switches 233 and 234.

The balancing switch 231 is opened in response to the control signal C3 having the disable level, and the connection switches 233 and 234 are closed in response to the control signal C4 having the enable level. Accordingly, balancing between the battery packs 210a and 210b ends, and the nodes N1 and N2 may be connected to the link terminals DC(+) and DC(-), respectively. In addition, the processor 240 transfers the control signals C1 and C2 having the disable level to the switching circuits 220a and 220b of the battery packs 210a and 210b, and the positive switches 221a and 221b and negative switches 222a and 222b of the battery packs 210a and 210b may be opened in response to control signals C1 and C2 having the disable level. In some embodiments, the processor 240 may output the control signals C1 and C2 having the disable level before outputting the control signal C3 having the disable level.

In some embodiments, the processor 240 may end the balancing mode when the difference between the voltage of the battery pack 210a and the voltage of the battery pack 210b is smaller than the predetermined voltage. In some embodiments, the processor 240 may end the balancing mode when power is supplied from the battery packs 210a and 210b to the external device 20.

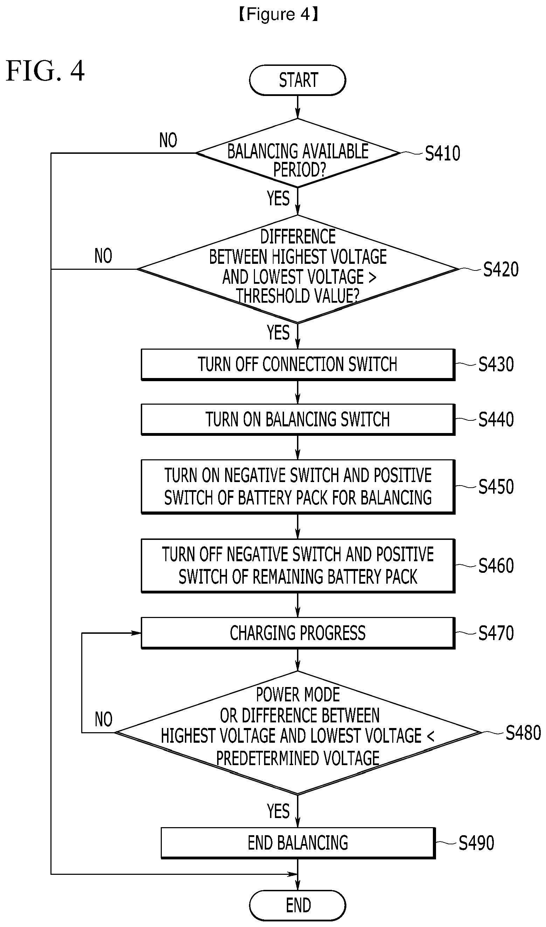

FIG. 4 is a flowchart illustrating an example of a battery pack balancing method of a battery device according to an exemplary embodiment.

Referring to FIG. 4, when the battery device satisfies a predetermined condition (or a "first predetermined condition") (S410 and S420), the processor 240 performs pack balancing among at least some of a plurality of battery packs (S430 to S490). In some embodiments, when the battery device enters a balancing available period (e.g., a balancing mode) (S410), the processor (e.g., 240 of FIG. 2) of the battery device may detect voltages of a plurality of battery packs included in the battery device, and compare a difference between a highest voltage and a lowest voltage among the voltages of the plurality of battery packs with a threshold voltage (S420). When the difference between the highest voltage and the lowest voltage exceeds the threshold voltage (S420), the processor 240 may perform pack balancing between the battery pack (e.g., 210a of FIG. 1) having the highest voltage and the battery pack (e.g., 210b of FIG. 1) having the lowest voltage (S430-S490). That is, the first predetermined condition may include a condition in which the battery device is in the balancing available period (e.g., a condition in which the battery device is in a mode in which power supply from the battery device to an external device is not required). Alternatively, the first predetermined condition may include a condition in which the difference between the highest voltage and the lowest voltage exceeds the threshold voltage. In some embodiments, the processor 240 may perform pack balancing between one or more battery packs having the highest voltage and one or more battery packs having the lowest voltage.

The processor 240 opens the connection switch (e.g. 233 of FIG. 2) for connection between the positive switches (e.g., 221a and 221b of FIG. 2) and the positive link terminal (e.g., DC(+) of FIG. 2) and a connection switch (e.g., 234 of FIG. 2) for connection between the negative switches (e.g., 222a and 222b of FIG. 2) and the negative link terminal (e.g., DC(-) of FIG. 2) (S430). The processor 240 opens the connection switches 233 and 234 to block the connection between the positive switches 221a and 221b and the positive link terminal DC(+) and the negative switches 222a and 222b and the negative link terminal DC(-) (S430).

The processor 240 closes the balancing switch (e.g., 231 of FIG. 2) (S440). The processor 240 closes the balancing switch 231 to connect the balancing resistor (e.g., 232 of FIG. 2) to the battery packs 210a and 210b in parallel.

In addition, the processor 240 closes the negative switch 222a and positive switch 221a of the battery pack 210a having the highest voltage and the negative switch 222b and the positive switch 221b of the battery pack 210b having the lowest voltage (S440). Also, the processor 240 maintains an open state of a negative switch and a positive switch of a battery pack except for the battery packs 210a and 210b having the highest and lowest voltages among the plurality of battery packs (S450).

Accordingly, a current flows from the battery pack 210a having the highest voltage to the battery pack 210b having the lowest voltage and the balancing resistor 232, so that the battery pack 210b having the lowest voltage is charged (S470).

When a predetermined condition (or a "second predetermined condition") (S480) is satisfied, the processor 240 ends balancing (S490). In some embodiments, the processor 240 may monitor a difference between the voltage of the battery pack 210a and the voltage of the battery pack 210b as the battery pack 210b having the lowest voltage is charged (S480). When the difference between the voltage of the battery pack 210a and the voltage of the battery pack 210b is smaller than the predetermined voltage (S480), the processor 240 ends pack balancing (S490). The predetermined voltage is a voltage lower than the threshold voltage. That is, the predetermined condition may include a condition in which the difference between the voltage of the battery pack 210a and the voltage of the battery pack 210b is smaller than the predetermined voltage. In some embodiments, even if the condition in which the difference between the voltage of the battery pack 210a and the voltage of the battery pack 210b is smaller than the predetermined voltage is not satisfied, when the battery device is switched to a power source mode, the processor 240 may end pack balancing (S490). When power supply from the battery device to the external device is required, the processor 240 may end pack balancing and supply power to the external device. That is, the predetermined condition may include a condition in which the battery device is in a mode in which power supply from the battery device to the external device is required.

While this invention has been described in connection with what is presently considered to be practical exemplary embodiments, it is to be understood that the invention is not limited to the disclosed embodiments. However, the scope of the invention is solely defined by the appended claims.

## Claims

1. A battery device (100, 200) comprising:
a positive link terminal and a negative link terminal for connection to an external device (10);
a plurality of battery packs (110) including a first battery pack and a second battery pack;
a plurality of positive switches (121, 221) respectively connected between positive terminals of the plurality of battery packs (110) and a first node (N1);
a plurality of negative switches (122, 222) respectively connected between negative terminals of the plurality of battery packs (110) and a second node (N2);
a first switch (233) connected between the first node and the positive link terminal;
a second switch (234) connected between the second node and the negative link terminal;
a processor (140, 240) for controlling the plurality of positive switches, the plurality of negative switches, the first switch (233), the second switch (234), and the third switch (231) to perform balancing between at least some of the plurality of battery packs (110) **characterized in that** the battery device further comprises a third switch (231) and a resistor (232) connected in series between the first node (N1) and the second node (N2), and wherein:
when a first predetermined condition is satisfied,
the processor (140, 240) is configured to open the first switch (233) and the second switch (234),
close the third switch (231),
close negative switches (122, 222) connected to the negative terminals of the first battery pack and the second battery pack among the plurality of negative switches, and positive switches (121, 221) connected to the positive terminals of the first battery pack and the second battery pack among the plurality of positive switches, and
perform balancing between the first battery pack and the second battery pack.

2. The battery device (100, 200) of claim 1, wherein:
the first predetermined condition includes a condition in which a voltage difference between the first battery pack and the second battery pack exceeds a threshold voltage.

3. The battery device (100, 200) of claim 2, wherein:
the first battery pack is a battery pack having a highest voltage among the plurality of battery packs, and
the second battery pack is a battery pack having a lowest voltage among the plurality of battery packs.

4. The battery device (100, 200) of claim 3, wherein:
the first predetermined condition includes a condition in which the battery device is in a mode in which power supply from the battery device to the external device is not required.

5. The battery device (100, 200) of claim 1, wherein:
the processor (140, 240) is configured to end the balancing when a second predetermined condition is satisfied.

6. The battery device (100, 200) of claim 5, wherein:
the second predetermined condition includes a condition in which a voltage difference between the first battery pack and the second battery pack is less than a predetermined voltage.

7. The battery device (100, 200) of claim 5, wherein:
the second predetermined condition includes a condition in which the battery device is in a mode in which power supply from the battery device to the external device is required.

8. A battery device comprising:
a positive link terminal and a negative link terminal connected to an external device;
a plurality of battery packs (110) including a first battery pack and a second battery pack;
a plurality of positive switches (121, 221) respectively connected between positive terminals of the plurality of battery packs and a first node (N1);
a plurality of negative switches (122, 222) respectively connected between negative terminals of the plurality of battery packs and a second node (N2);
a balancing circuit (130, 230) connected to the first node (N1), the second node (N2), the positive link terminal, and the negative link terminal; and
a processor (140, 240) for controlling the balancing circuit (130, 230) to perform balancing between at least some of the plurality of battery packs;
**characterized in that**
when a first predetermined condition is satisfied,
the processor (140, 240) is configured to control the balancing circuit (130, 230) to block a connection between the first node (N1) and the positive link terminal and a connection between the second node (N2) and the negative link terminal,
close negative switches (122, 222) connected to the negative terminals of the first battery pack and the second battery pack among the plurality of negative switches, and positive switches (121, 221) connected to the positive terminals of the first battery pack and the second battery pack among the plurality of positive switches, and,
perform balancing between the first battery pack and the second battery pack.

9. The battery device (100, 200) of claim 8, wherein:
the first predetermined condition includes a condition in which a voltage difference between the first battery pack and the second battery pack exceeds a threshold voltage.

10. The battery device (100, 200) of claim 8, wherein:
the processor is configured to end the balancing when a second predetermined condition is satisfied.

11. A balancing method of a battery device including a positive link terminal and a negative link terminal connected to an external device, a plurality of battery packs including a first battery pack and a second battery pack, a plurality of positive switches respectively connected between positive terminals of the plurality of battery packs and a first node, and a plurality of negative switches respectively connected between negative terminals of the plurality of battery packs and a second node, the balancing method **characterized by**:
when a predetermined condition is satisfied, blocking (S430) a connection between the positive switch and the positive link terminal and a connection between the negative switch and the negative link terminal;
connecting (S440) a resistor to the first battery pack and the second battery pack in parallel; and
supplying a current from the first battery pack to the second battery pack and the resistor by closing negative switches connected to the negative terminals of the first battery pack and the second battery pack among the plurality of negative switches, and positive switches connected to the positive terminals of the first battery pack and the second battery pack among the plurality of positive switches.

12. The balancing method of claim 11, wherein:
the predetermined condition includes a condition in which a voltage difference between the first battery pack and the second battery pack exceeds a threshold voltage.

13. The balancing method of claim 14, wherein:
the predetermined condition further includes a condition in which the battery device is in a mode in which power supply from the battery device to the external device is not required.

## Patentansprüche

1. Batterievorrichtung (100, 200), umfassend:
einen positiven Kopplungsanschluss und einen negativen Kopplungsanschluss zum Verbinden an einer externen Vorrichtung (10);
eine Mehrzahl von Batteriepacks (110), umfassend einen ersten Batteriepack und einen zweiten Batteriepack;
eine Mehrzahl positiver Schalter (121, 221), welche jeweils zwischen positiven Anschlüssen der Mehrzahl von Batteriepacks (110) und einem ersten Knoten (N1) geschaltet sind;
eine Mehrzahl negativer Schalter (122, 222), welche jeweils zwischen negativen Anschlüssen der Mehrzahl von Batteriepacks (110) und einem zweiten Knoten (N2) geschaltet sind;
einen ersten Schalter (233), welcher zwischen dem ersten Knoten und dem positiven Kopplungsanschluss geschaltet ist;
einen zweiten Schalter (234), welcher zwischen dem zweiten Knoten und dem negativen Kopplungsanschluss geschaltet ist;
einen Prozessor (140, 240) zum Steuern der Mehrzahl positiver Schalter, der Mehrzahl negativer Schalter, des ersten Schalters (233), des zweiten Schalters (234) und des dritten Schalters (231), um ein Ausgleichen zwischen wenigstens einiger der Mehrzahl von Batteriepacks (110) durchzuführen, **dadurch gekennzeichnet, dass** die Batterievorrichtung ferner einen dritten Schalter (231) und einen Widerstand (232) umfasst, welche in Serie zwischen dem ersten Knoten (N1) und dem zweiten Knoten (N2) geschaltet sind, und wobei:
wenn eine erste vorbestimmte Bedingung erfüllt ist,
der Prozessor (140, 240) dazu eingerichtet ist, den ersten Schalter (233) und den zweiten Schalter (234) zu öffnen,
den dritten Schalter (231) zu schließen,
negative Schalter (122, 222), welche mit den negativen Anschlüssen des ersten Batteriepacks und des zweiten Batteriepacks verbunden sind, unter der Mehrzahl negativer Schalter und positive Schalter (121, 221), welche mit den positiven Anschlüssen des ersten Batteriepacks und des zweiten Batteriepacks verbunden sind, unter der Mehrzahl positiver Schalter zu schließen, und
ein Ausgleichen zwischen dem ersten Batteriepack und dem zweiten Batteriepack durchzuführen.

2. Batterievorrichtung (100, 200) nach Anspruch 1, wobei:
die erste vorbestimmte Bedingung eine Bedingung umfasst, in welcher eine Spannungsdifferenz zwischen dem ersten Batteriepack und dem zweiten Batteriepack eine Schwellenspannung übersteigt.

3. Batterievorrichtung (100, 200) nach Anspruch 2, wobei:
der erste Batteriepack ein Batteriepack ist, welcher eine höchste Spannung unter der Mehrzahl von Batteriepacks aufweist, und
der zweite Batteriepack ein Batteriepack ist, welcher eine geringste Spannung unter der Mehrzahl von Batteriepacks aufweist.

4. Batterievorrichtung (100, 200) nach Anspruch 3, wobei:
die erste vorbestimmte Bedingung eine Bedingung umfasst, in welcher die Batterievorrichtung in einem Modus ist, in welchem eine Leistungsversorgung von der Batterievorrichtung zu der externen Vorrichtung nicht erforderlich ist.

5. Batterievorrichtung (100, 200) nach Anspruch 1, wobei:
der Prozessor (140, 240) dazu eingerichtet ist, das Ausgleichen zu beenden, wenn eine zweite vorbestimmte Bedingung erfüllt ist.

6. Batterievorrichtung (100, 200) nach Anspruch 5, wobei:
die zweite vorbestimmte Bedingung eine Bedingung umfasst, in welcher eine Spannungsdifferenz zwischen dem ersten Batteriepack und dem zweiten Batteriepack geringer als eine vorbestimmte Spannung ist.

7. Batterievorrichtung (100, 200) nach Anspruch 5, wobei:
die zweite vorbestimmte Bedingung eine Bedingung umfasst, in welcher die Batterievorrichtung in einem Modus ist, in welchem eine Leistungsversorgung von der Batterievorrichtung zu der externen Vorrichtung erforderlich ist.

8. Batterievorrichtung, umfassend:
einen positiven Kopplungsanschluss und einen negativen Kopplungsanschluss, welche mit einer externen Vorrichtung verbunden sind;
eine Mehrzahl von Batteriepacks (110), umfassend einen ersten Batteriepack und einen zweiten Batteriepack;
eine Mehrzahl positiver Schalter (121, 221), welche jeweils zwischen positiven Anschlüssen der Mehrzahl von Batteriepacks und einem ersten Knoten (N1) geschaltet sind;
eine Mehrzahl negativer Schalter (122, 222), welche jeweils zwischen negativen Anschlüssen der Mehrzahl von Batteriepacks und einem zweiten Knoten (N2) geschaltet sind;
eine Ausgleichsschaltung (130, 230), welche zwischen dem ersten Knoten (N1), dem zweiten Knoten (N2), dem positiven Kopplungsanschluss und dem negativen Kopplungsanschluss geschaltet ist; und
einen Prozessor (140, 240) zum Steuern der Ausgleichsschaltung (130, 230), um ein Ausgleichen zwischen wenigstens einiger der Mehrzahl von Batteriepacks durchzuführen, **dadurch gekennzeichnet, dass**
wenn eine erste vorbestimmte Bedingung erfüllt ist,
der Prozessor (140, 240) dazu eingerichtet ist, die Ausgleichsschaltung (130, 230) zu steuern, um eine Verbindung zwischen dem ersten Knoten (N1) und dem positiven Kopplungsanschluss und eine Verbindung zwischen dem zweiten Knoten (N2) und dem negativen Kopplungsanschluss zu blockieren,
negative Schalter (122, 222), welche mit den negativen Anschlüssen des ersten Batteriepacks und des zweiten Batteriepacks verbunden sind, unter der Mehrzahl negativer Schalter und positive Schalter (121, 221), welche mit den positiven Anschlüssen des ersten Batteriepacks und des zweiten Batteriepacks verbunden sind, unter der Mehrzahl positiver Schalter zu schließen, und
ein Ausgleichen zwischen dem ersten Batteriepack und dem zweiten Batteriepack durchzuführen.

9. Batterievorrichtung (100, 200) nach Anspruch 8, wobei:
die erste vorbestimmte Bedingung eine Bedingung umfasst, in welcher eine Spannungsdifferenz zwischen dem ersten Batteriepack und dem zweiten Batteriepack eine Schwellenspannung übersteigt.

10. Batterievorrichtung (100, 200) nach Anspruch 8, wobei:
der Prozessor dazu eingerichtet ist, das Ausgleichen zu beenden, wenn eine zweite vorbestimmte Bedingung erfüllt ist.

11. Ausgleichsverfahren einer Batterievorrichtung, umfassend einen positiven Kopplungsanschluss und einen negativen Kopplungsanschluss, welche mit einer externen Vorrichtung verbunden sind, eine Mehrzahl von Batteriepacks, welche einen ersten Batteriepack und einen zweiten Batteriepack umfassen, eine Mehrzahl positiver Schalter, welche jeweils zwischen positiven Anschlüssen der Mehrzahl von Batteriepacks und einem ersten Knoten geschaltet sind, und eine Mehrzahl negativer Schalter, welche jeweils zwischen negativen Anschlüssen der Mehrzahl von Batteriepacks und einem zweiten Knoten geschaltet sind, wobei das Ausgleichsverfahren **gekennzeichnet durch**:
wenn eine vorbestimmte Bedingung erfüllt ist, Blockieren (S430) einer Verbindung zwischen dem positiven Schalter und dem positiven Kopplungsanschluss und einer Verbindung zwischen dem negativen Schalter und dem negativen Kopplungsanschluss;
Parallelschalten (S440) eines Widerstands mit dem ersten Batteriepack und dem zweiten Batteriepack; und
Liefern eines Stroms von dem ersten Batteriepack zu dem zweiten Batteriepack und dem Widerstand durch Schließen negativer Schalter, welche mit den negativen Anschlüssen des ersten Batteriepacks und des zweiten Batteriepacks verbunden sind, unter der Mehrzahl negativer Schalter und positiver Schalter, welche mit den positiven Anschlüssen des ersten Batteriepacks und des zweiten Batteriepacks verbunden sind, unter der Mehrzahl positiver Schalter.

12. Ausgleichsverfahren nach Anspruch 11, wobei:
die vorbestimmte Bedingung eine Bedingung umfasst, in welcher eine Spannungsdifferenz zwischen dem ersten Batteriepack und dem zweiten Batteriepack eine Schwellenspannung übersteigt.

13. Ausgleichsverfahren nach Anspruch 14, wobei:
die vorbestimmte Bedingung ferner eine Bedingung umfasst, in welcher die Batterievorrichtung in einem Modus ist, in welchem eine Leistungsversorgung von der Batterievorrichtung zu der externen Vorrichtung nicht erforderlich ist.

## Revendications

1. Dispositif de batterie (100, 200) comprenant :
une borne de liaison positive et une borne de liaison négative pour la connexion à un dispositif externe (10) ;
une pluralité de blocs-batteries (110) incluant un premier bloc-batterie et un second bloc-batterie ;
une pluralité de commutateurs positifs (121, 221) respectivement connectés entre des bornes positives de la pluralité de blocs-batteries (110) et un premier nœud (N1) ;
une pluralité de commutateurs négatifs (122, 222) respectivement connectés entre des bornes négatives de la pluralité de blocs-batteries (110) et un second nœud (N2) ;
un premier commutateur (233) connecté entre le premier nœud et la borne de liaison positive ;
un deuxième commutateur (234) connecté entre le second nœud et la borne de liaison négative ;
un processeur (140, 240) pour commander la pluralité de commutateurs positifs, la pluralité de commutateurs négatifs, le premier commutateur (233), le deuxième commutateur (234) et le troisième commutateur (231) pour réaliser un équilibrage entre au moins une partie de la pluralité de blocs-batteries (110), **caractérisé en ce que** le dispositif de batterie comprend en outre un troisième commutateur (231) et une résistance (232) connectés en série entre le premier nœud (N1) et le second nœud (N2), et
dans lequel :
lorsqu'une première condition prédéterminée est remplie,
le processeur (140, 240) est configuré pour ouvrir le premier commutateur (233) et le deuxième commutateur (234), fermer le troisième commutateur (231),
fermer les commutateurs négatifs (122, 222) connectés aux bornes négatives du premier bloc-batterie et du second bloc-batterie parmi la pluralité de commutateurs négatifs, et les commutateurs positifs (121, 221) connectés aux bornes positives du premier bloc-batterie et du second bloc-batterie parmi la pluralité de commutateurs positifs, et
réaliser un équilibrage entre le premier bloc-batterie et le second bloc-batterie.

2. Dispositif de batterie (100, 200) selon la revendication 1, dans lequel :
la première condition prédéterminée inclut une condition dans laquelle une différence de tension entre le premier bloc-batterie et le second bloc-batterie dépasse une tension seuil.

3. Dispositif de batterie (100, 200) selon la revendication 2, dans lequel :
le premier bloc-batterie est le bloc-batterie ayant la tension la plus élevée parmi la pluralité de blocs-batteries, et
le second bloc-batterie est le bloc-batterie ayant la tension la plus faible parmi la pluralité de blocs-batteries.

4. Dispositif de batterie (100, 200) selon la revendication 3, dans lequel :
la première condition prédéterminée inclut une condition dans laquelle le dispositif de batterie est dans un mode dans lequel une alimentation électrique du dispositif de batterie au dispositif externe n'est pas requise.

5. Dispositif de batterie (100, 200) selon la revendication 1, dans lequel :
le processeur (140, 240) est configuré pour mettre fin à l'équilibrage lorsqu'une seconde condition prédéterminée est remplie.

6. Dispositif de batterie (100, 200) selon la revendication 5, dans lequel :
la seconde condition prédéterminée inclut une condition dans laquelle une différence de tension entre le premier bloc-batterie et le second bloc-batterie est inférieure à une tension prédéterminée.

7. Dispositif de batterie (100, 200) selon la revendication 5, dans lequel :
la seconde condition prédéterminée inclut une condition dans laquelle le dispositif de batterie est dans un mode dans lequel une alimentation électrique du dispositif de batterie au dispositif externe est requise.

8. Dispositif de batterie comprenant :
une borne de liaison positive et une borne de liaison négative connectées à un dispositif externe ;
une pluralité de blocs-batteries (110) incluant un premier bloc-batterie et un second bloc-batterie ;
une pluralité de commutateurs positifs (121, 221) respectivement connectés entre des bornes positives de la pluralité de blocs-batteries et un premier nœud (N1) ;
une pluralité de commutateurs négatifs (122, 222) respectivement connectés entre des bornes négatives de la pluralité de blocs-batteries et un second nœud (N2) ;
un circuit d'équilibrage (130, 230) connecté au premier nœud (N1), au second nœud (N2), à la borne de liaison positive et à la borne de liaison négative ; et
un processeur (140, 240) pour commander le circuit d'équilibrage (130, 230) afin de réaliser un équilibrage entre au moins une partie de la pluralité de blocs-batteries ;
**caractérisé en ce que**
lorsqu'une première condition prédéterminée est remplie,
le processeur (140, 240) est configuré pour commander le circuit d'équilibrage (130, 230) afin de bloquer une connexion entre le premier nœud (N1) et la borne de liaison positive et une connexion entre le second nœud (N2) et la borne de liaison négative,
fermer les commutateurs négatifs (122, 222) connectés aux bornes négatives du premier bloc-batterie et du second bloc-batterie parmi la pluralité de commutateurs négatifs, et les commutateurs positifs (121, 221) connectés aux bornes positives du premier bloc-batterie et du second bloc-batterie parmi la pluralité de commutateurs positifs, et,
réaliser un équilibrage entre le premier bloc-batterie et le second bloc-batterie.

9. Dispositif de batterie (100, 200) selon la revendication 8, dans lequel :
la première condition prédéterminée inclut une condition dans laquelle une différence de tension entre le premier bloc-batterie et le second bloc-batterie dépasse une tension seuil.

10. Dispositif de batterie (100, 200) selon la revendication 8, dans lequel :
le processeur est configuré pour mettre fin à l'équilibrage lorsqu'une seconde condition prédéterminée est remplie.

11. Procédé d'équilibrage d'un dispositif de batterie incluant une borne de liaison positive et une borne de liaison négative connectées à un dispositif externe, une pluralité de blocs-batteries incluant un premier bloc-batterie et un second bloc-batterie, une pluralité de commutateurs positifs respectivement connectés entre des bornes positives de la pluralité de blocs-batteries et un premier nœud, et une pluralité de commutateurs négatifs respectivement connectés entre des bornes négatives de la pluralité de blocs-batteries et un second nœud, le procédé d'équilibrage étant **caractérisé par** :
lorsqu'une condition prédéterminée est remplie, le blocage (S430) d'une connexion entre le commutateur positif et la borne de liaison positive et d'une connexion entre le commutateur négatif et la borne de liaison négative ;
la connexion (S440) d'une résistance au premier bloc-batterie et au second bloc-batterie en parallèle ; et
la fourniture d'un courant du premier bloc-batterie au second bloc-batterie et à la résistance en fermant des commutateurs négatifs connectés aux bornes négatives du premier bloc-batterie et du second bloc-batterie parmi la pluralité de commutateurs négatifs, et des commutateurs positifs connectés aux bornes positives du premier bloc-batterie et du second bloc-batterie parmi la pluralité de commutateurs positifs.

12. Procédé d'équilibrage selon la revendication 11, dans lequel :
la condition prédéterminée inclut une condition dans laquelle la différence de tension entre le premier bloc-batterie et le second bloc-batterie dépasse une tension seuil.

13. Procédé d'équilibrage selon la revendication 14, dans lequel :
la condition prédéterminée inclut en outre une condition dans laquelle le dispositif de batterie est dans un mode dans lequel une alimentation électrique du dispositif de batterie au dispositif externe n'est pas requise.
